# EUROPÄISCHE PATENTSCHRIFT

(11) **EP 1 652 963 B1**
(45) Veröffentlichungstag und Bekanntmachung des Hinweises auf die Patenterteilung: **10.06.2009**
(21) Anmeldenummer: 05020436.1
(22) Anmeldetag: 20.09.2005
(51) Int. Cl.: C23C 28/00, C23C 14/35

(54) **Oberflächenveredeltes Objekt, Verfahren zu dessen Herstellung sowie Verwendung des Objektes**
Surface-improved object, method of its manufacture and use of the object
Objet à surface améliorée, son procédé de fabrication et utilisation de l'objet

(30) Priorität: 27.10.2004 DE 102004052169
(43) Veröffentlichungstag der Anmeldung: 03.05.2006
(73) Patentinhaber: Fraunhofer-Gesellschaft zur Förderung der angewandten Forschung e.V., 80686 München (DE)
(72) Erfinder: Fietzke, Fred, Dr., 01728 Hänichen (DE); Goedicke, Klaus, 01307 Dresden (DE); Glöss, Daniel, 01279 Dresden (DE); Frach, Peter, Dr., 01454 Radeberg (DE)

(56) Entgegenhaltungen:
- WO-A-03/051787
- WO-A-20/04067464
- DE-A1- 10 210 465
- US-A1- 2002 114 945

## Beschreibung

Die Erfindung betrifft ein oberflächenveredeltes Objekt, das aus einem Grundkörper und einer multifunktionalen Beschichtung besteht, ein Verfahren zu dessen Herstellung sowie Verwendungsmöglichkeiten des Objektes.

Anwendungsgebiete für oberflächenveredelte Objekte finden sich beispielsweise in Haushalttechnik, Werkzeugindustrie, Medizintechnik, Lebensmittelindustrie, Architektur und Raumausstattung. Der Gebrauchswert vieler Objekte wird durch eine Modifizierung der Oberflächen eines Grundkörpers deutlich erhöht oder überhaupt erst erreicht. Die Beschichtung von Oberflächen ist deshalb eine Schlüsseltechnologie für zahlreiche Branchen. Häufig werden durch Beschichtungen oder Modifizierungen der Oberfläche von Objekten Kratzfestigkeit, dekoratives Erscheinungsbild, Korrosionsbeständigkeit, diffusionshemmende Wirkungen, Benetzbarkeit, optische oder elektrische Eigenschaften oder andere Funktionen erreicht. Entsprechend dem jeweiligen Anwendungszweck werden oft mehrere Funktionen gleichzeitig angestrebt. Es sind viele Fälle bekannt, bei denen die Multifunktionalität nicht durch eine Oberflächenschicht allein erreichbar ist, sondern eine mehrlagige Beschichtung mit unterschiedlichen, übereinander angeordneten Einzelschichten erforderlich ist. Die Notwendigkeit für mehrlagige Beschichtungen - so genannte Multilayer - ergibt sich auch häufig aus Defiziten der Beschichtung oder unerwünschten Wechselwirkungen zwischen Grundkörper und Schicht. So sind diffusionshemmende, haftvermittelnde oder glättende Unter- oder Zwischenschichten bei vielen Beschichtungen unverzichtbar.

Entsprechend der Vielfalt der angestrebten Funktionen, zu beschichtender Grundkörper, für die Beschichtungen ausgewählter Materialien und der im Beschichtungsprozess auftretenden Belastungen, etwa durch erhöhte Temperatur, kommen sehr unterschiedliche Beschichtungsverfahren zum Einsatz. In Standardwerken sind Grundlagen dieser Verfahren und ihr fortgeschrittener Stand ausführlich erläutert. Die Verfahrenspalette reicht von der Schmelzstauchbeschichtung über das Beschichten mit organischen Materialien, die elektrochemische Abscheidung, Sol-Gel-Techniken und viele andere Verfahren bis zu Vakuumbeschichtungsverfahren. Für letztere seien beispielhaft die Bücher K. Mertz, H. Jehn (Hrsg.) "Praxishandbuch moderner Beschichtungen", Carl-Hanser-Verlag München/Wien 2001 und G. Kienel "Vakuumbeschichtung" Bd. 1-5, VDI-Verlag Düsseldorf 1994, genannt.

Für eine bestimmte Gruppe von Objekten müssen eine hohe mechanische und chemische Widerstandsfähigkeit und die Eignung zu leichter, unkomplizierter Reinigung mit ästhetischem Aussehen verknüpft sein. Gleichzeitig soll ein hohes Maß an Freiheitsgraden für die Auswahl des Materials des Grundkörpers und dessen Bearbeitungsverfahren erhalten bleiben. Die Grundkörper sollen aus unterschiedlichen, metallischen Werkstoffen herstellbar sein, und es sollen Fügetechniken wie Schweißen und Löten für die Herstellung der Grundkörper nutzbar sein. Entsprechend dem Stand der Technik können derartige Körper mit einer organischen Beschichtung, z. B. mit Metall-pigmentiertem Lack, versehen werden. Derartige Beschichtungen erfüllen zwar die Forderungen hinsichtlich Korrosionsschutz und dekorativer Wirkung, weisen jedoch Defizite bezüglich Kratzfestigkeit und Verschleißschutz auf. Beschichtungen mit Sol-Gel-Verfahren können je nach Modifizierung der Ausgangsstoffe ebenfalls korrosionsgeschützte Oberflächen und in bestimmten Fällen auch photohalbleitende Eigenschaften der Oberfläche ausbilden, wodurch eine Reinigung erleichtert werden kann. Hinsichtlich Kratzfestigkeit, Verschleißschutz und dekorativer Wirkung werden jedoch nur minimale Anforderungen erfüllt. In den meisten Fällen muss deshalb die Oberflächenmodifikation der Objekte dieser Gruppe durch chemische oder elektrochemische Abscheidung erfolgen. Am verbreitetsten ist die stromlose oder galvanische Veredelung der Grundkörper mit Nickel oder Chrom (siehe z. B. in W. Dettmer, "Handbuch der Galvanotechnik" Bd. 1 und 2, Carl-Hanser-Verlag München 1966).

Obwohl zahlreiche Verfahren und Zusätze zum Verbessern der galvanischen Schichten bekannt sind, haftet allen Nickelschichten der Nachteil begrenzter Korrosionsschutzwirkung und eingeschränkter Kratzfestigkeit an. Darüber hinaus wird die Farbe von Nickelschichten für anspruchsvolle Anwendungen zum Teil nicht akzeptiert, und im Körperkontakt können Allergien auftreten. Es ist deshalb üblich, derartige Grundkörper zu verchromen. Insbesondere zeichnen sich Hartchromschichten durch eine im Allgemeinen ausreichende Kratzfestigkeit und ansprechende optische Wirkung aus. Die Forderung nach Korrosionsbeständigkeit gegenüber gasförmigen und flüssigen Reagenzien ist dagegen nur durch Verwendung vergleichsweise dicker Unter- und Zwischenschichten zu erreichen, z. B. Kupfer mit einer Dicke von 10 µm bis 100 µm und zusätzlich Nickel mit 10 µm bis 50 µm unter Chrom mit einer Dicke von 2 µm bis 25 µm. Trotz dieser Maßnahmen bestehen in diesen Schichtsystemen häufig der Zustand hoher innerer Spannungen und die Gefahr von Delaminationen. Nachteilig ist weiterhin die Verwendung von Bädern mit sechswertigen Chromionen, die hochgradig umweltbedenklich sind und deshalb Zusatzkosten für das Erzeugen geschlossener Stoffkreisläufe erfordern.

Objekte, deren Grundkörper aus Aluminium, Magnesium, Tantal oder Titan oder deren Legierungen bestehen, werden auch durch anodische Oxydationen der Oberfläche des Grundkörpers veredelt. Beispiele für solche Objekte sind hart eloxierte Maschinenbauteile aus Aluminiumlegierungen oder prothetische Implantate der Humanmedizin aus Titan. Je nach Einzelfall bestehen jedoch zum Teil erhebliche Diskrepanzen zu den Anforderungen im Bezug auf Kratzfestigkeit und ästhetische Wirkungen.

Für multifunktionale Oberflächen werden seit einigen Jahren zunehmend auch Eigenschaften wie definierte hohe oder geringe Benetzbarkeit, z. B. Hydrophobie oder Hydrophilie, Selbstreinigungseffekte, Biokompatibilität oder antibakterielle Wirkung angestrebt. Dafür spielen photohalbleitende Materialien wie Titanoxid eine Schlüsselrolle. In der wissenschaftlichen und Patentliteratur werden dazu fast alle bekannten Abscheideverfahren vorgeschlagen, wobei die so genannte Immobilisierung, d. h. die haftfeste Aufbringung der Schicht auf den Grundkörper, und die Größe der photohalbleitenden Effekte im Zentrum der Entwicklungen stehen. Bisher bekannt gewordene Anwendungen nutzen meist das Abscheiden von TiO₂-Mikropartikeln aus der flüssigen Phase oder die chemische Dampfphasenabscheidung von TiO₂-Schichten.

Bei so genannten Sol-Gel-Verfahren (DE 199 62 055 A1, DE 102 35 803 A1) wird zunächst eine Titanoxid-Bestandteile aufweisende Flüssigkeit bzw. Dispersion auf ein zu beschichtendes Objekt aufgetragen. Das Auftragen der Flüssigkeit/Dispersion kann beispielsweise durch Spritzen, Tauchen oder Streichen erfolgen. Daran anschließend wird die flüssige Schicht ausgetrocknet und bei Bedarf zusätzlich gehärtet. Mit Sol-Gel-Verfahren lassen sich hohe Beschichtungsraten erzielen. Nachteile ergeben sich daraus, dass derart hergestellte Schichten neben Titanoxid weitere aus der Flüssigkeit/Dispersion stammende Bestandteile aufweisen. Die weitgehende Bedeckung der Titanoxid-Partikel durch die Binder-Matrix ist somit auch mit eingeschränkten photokatalytischen Eigenschaften der abgeschiedenen Titanoxid-Schicht verbunden.

In der Fülle der Patentliteratur werden auch Vakuumbeschichtungsverfahren wie Arc-Verdampfung, Magnetron-Sputtern, Gasflusssputtern und reaktives Bedampfen zur Abscheidung von TiO₂-Schichten empfohlen. DE-A-102 10 465 offenbart in diesem zusammenhang ein Pulsmagnetron-Sputterverfahren.

Zu der eingangs genannten Gruppe von Objekten, deren Gebrauchswert durch eine multifunktionale Oberfläche bestimmt wird, gehören Werkzeuge, Uhrengehäuse, Schmuck- und Dekorelemente. Die Beschichtung von Grundkörpern für solche Anwendungen wird durch Verfahren der chemischen (CVD) oder physikalischen (PVD) Dampfabscheidung dominiert. Als Schichtmaterialien kommen vor allem Nitride, Karbide und Boride der Übergangsmetalle zum Einsatz. Besonders große Verbreitung hat Titannitrid gefunden. Es verbindet hohe Kratzfestigkeit und Widerstand gegen mechanischen und chemischen Verschleiß mit einem ansprechenden goldfarbenen Erscheinungsbild, das für dieses Anwendungsfeld häufig erwünscht ist. Insbesondere für Objekte der Uhren- und Schmuckindustrie wurden jedoch bisher trotz größter Anstrengungen keine Schichten oder Schichtsysteme gefunden, die durch CVD- oder PVD-Verfahren allein herstellbar sind und die in diesen Branchen üblichen Korrosionsschutzeigenschaften aufweisen. Generell wurden bisher trotz der großen Zahl der vorgeschlagenen Schichten, Schichtsysteme und Beschichtungsverfahren wohl gute Lösungen zur Funktionalisierung der Oberflächen von Objekten gefunden, jedoch sind keine Vorschläge bekannt, die gleichzeitig die Summe aller genannten Oberflächenfunktionen erfüllen.

Es ist deshalb Aufgabe der Erfindung, ein Objekt, bestehend aus einem metallischen Grundkörper und einer Beschichtung zu schaffen, welches die Funktionen hohe mechanische und chemische Widerstandsfähigkeit, Eignung zu leichter, unkomplizierter Reinigung und edles metallisches Erscheinungsbild kombiniert. Gleichzeitig soll das Objekt physiologisch unbedenklich sein, d. h. keine Hautreaktionen hervorrufen und nach Möglichkeit der Bedeckung mit Mikroorganismen entgegenwirken. Im Interesse niedriger Herstellungskosten sollen zur Fertigung des Grundkörpers zahlreiche unterschiedliche Form- und Fügetechnologien einschließlich Schweißen und Löten zulässig sein. Die Schichtabscheidung soll frei von umweltbelastenden Faktoren sein. Des Weiteren soll ein Verfahren zum Herstellen des Objektes sowie Anwendungsmöglichkeiten des Objektes aufgezeigt werden.

Die Lösung der Aufgabe ergibt sich durch die Gegenstände mit den Merkmalen der Patentansprüche 1, 10 und 11. Weitere vorteilhafte Ausgestaltungen der Erfindung ergeben sich aus den abhängigen Ansprüchen.

Erfindungsgemäßes Objekt und erfindungsgemäßes Verfahren zu dessen Herstellung sind charakterisiert durch einen metallischen Grundkörper, der zumindest auf einem Oberflächenabschnitt mit einer Oberflächenstruktur versehen wird, die einen Mittenrauheitswert von R_{A} größer als 0,4 µm aufweist. Zum einem werden dadurch unerwünschte Reflexionen und Lichtinterferenzen auf dem beschichteten Grundkörper vermieden. Zum anderen wird durch diese Vorbehandlung des Grundkörpers eine einheitliche Topologie der Oberfläche gesichert, auch wenn der Grundkörper mittels Schweißen, Löten oder anderen Fügeverfahren aus mehreren Teilstücken und ggf. unterschiedlichen Materialien zusammengesetzt ist.

Die erfindungsgemäße Rauheit ist darüber hinaus optimal für hohe photokatalytische Wirkungen einer erfindungsgemäß aufgetragenen Deckschicht aus Titandioxid. Zunächst wird jedoch eine Titanschicht, als Unterschicht einer aufzutragenden Doppelschicht durch ein plasmaaktiviertes Verfahren der physikalischen Dampfabscheidung (PVD) zumindest auf dem einen Oberflächenabschnitt aufgebracht. Ein derartiges Abscheideverfahren gewährleistet eine extrem hohe Haftfestigkeit der Titanschicht auf dem Grundkörper für zahlreiche Materialien, aus denen der Grundkörper bestehen kann, auch ohne weitere Haftvermittler- und Zwischenschichten. Weiterhin wird ein dichtes porenfreies Gefüge der Titanschicht erzeugt. Daraus resultiert eine hohe Korrosionsfestigkeit des Objektes gegenüber chemischen und elektrochemischen Beanspruchungen.

Die Titandioxidschicht wird nachfolgend ebenfalls durch ein plasmagestütztes PVD-Verfahren in Vakuumfolge zu der Abscheidung der Titanschicht, d. h. ohne zwischenzeitliche Unterbrechung des Vakuums aufgebracht. Damit wird nicht nur eine hohe Haftfestigkeit zwischen Titanschicht und Titandioxidschicht erreicht, sondern vor allem die angestrebte Kristallisation des Titandioxids günstig beeinflusst. Möglicherweise wirken sich Oberflächentopologie und Feinkörnigkeit der erfindungsgemäß aufgetragenen Titanschicht entscheidend auf die Keimbildung und das Kristallwachstum der anschließend aufgebrachten photohalbleitenden Titandioxidschicht aus.

Das Abscheiden beider Schichten in Vakuumfolge und gegebenenfalls unter Nutzung des gleichen Ausgangsmaterials wirkt sich darüber hinaus wirtschaftlich sehr günstig aus. Entsprechend der Erfindung ist die äußere Schicht des Objektes transparent und besteht zumindest partiell aus den kristallinen Phasen Anatas und/oder Rutil. Dabei beträgt die Summe der Anteile der kristallinen Phasen mehr als 20 Prozent.

Ein erfindungsgemäßes Objekt zeichnet sich durch ein mattes, dunkel metallisches, seidig glänzendes Aussehen, ähnlich Edelmetallen der Platingruppe, aus. Durch seine wesentlich höhere Oberflächenhärte als die von Stahl wird eine hohe Kratzfestigkeit erreicht.

Gegenüber zahlreichen sauren und basischen Medien, darunter Wasserdampf, handelsüblichen Industriereinigern und Handschweiß ist das Objekt korrosionsbeständig. Unter Einwirkung von kurzweiligem Licht (Sonnenlicht oder Kunstlicht mit kurzwelligen Anteilen) stellt sich ein energetischer Zustand der Oberfläche des Objektes ein, der zu einer vollständigen Benetzung mit Wasser führt (Super-Hydrophilie). Dadurch werden Reinigungsprozesse in wässrigen Medien wesentlich erleichtert. Laboruntersuchungen haben gezeigt, dass die Besiedlung mit Bakterien der Gattung Escherichia coli und Micrococcus luteus um mehrere Größenordnungen gegenüber dem unbeschichteten Grundkörper reduziert ist, wenn zuvor eine Beleuchtung des Objektes mit kurzwelligem Licht stattgefunden hat. Ebenso wird die Besiedelung des Objektes durch Algen unterbunden.

Als Materialien für den Grundkörper können beispielsweise Stahl, Neusilber, Messing, Bronze, Aluminium oder eine Aluminiumlegierung verwendet werden. Diese Metalle sind gut bearbeitbar durch Umformen, Spanen oder Fügen.

Die Dicke der auf einem Grundkörper abgeschiedenen Titan- bzw. Titandioxidschicht ist abhängig von dem/den Material/Materialien des Grundkörpers und den Anforderungen, die an ein Objekt gestellt werden. Besteht der Grundkörper eines Objektes beispielsweise aus einem weicheren Material und soll die Oberfläche des Objektes eine hohe Kratzfestigkeit aufweisen, so wird die Titanschicht zweckmäßiger Weise mit einer größeren Schichtdicke ausgebildet als bei einem Grundkörper, der aus einem härteren Material besteht.

Die Titanschicht wird als untere Schicht einer erfindungsgemäßen Doppelschicht mit einer Dicke von 0,1 µm bis 5 µm auf einem Grundkörper ausgebildet. Bei einer Ausführungsform der Erfindung wird die Titanschicht vorzugsweise mit einer Dicke von 0,3 µm bis 0,5 µm abgeschieden. Eine Titanschicht mit dieser Schichtdicke erfüllt auf einem Material wie beispielsweise Edelstahl hinreichend die Bedingungen für eine hohe Haftfestigkeit, weist gegenüber einer dickeren Titanschicht geringere innere Spannungen auf und ist mit niedrigeren Herstellungskosten verbunden.

Für das Ausbilden der Titandioxidschicht sind Schichtdicken in einem Bereich von 0,1 µm bis 5 µm geeignet. Dickere Titandioxidschichten innerhalb dieses Bereiches werden auf die Titanschicht aufgetragen, wenn beispielsweise hohe Anforderungen hinsichtlich Kratzschutz an die Oberfläche eines Objektes gestellt werden - dünnere, wenn beispielsweise der Grundkörper des Objektes aus einem Material mit begrenzter Temperaturbelastbarkeit besteht, wie bei einem Grundkörper aus Messing, bei welchem ab einer bestimmten Temperatur Zink-Bestandteile herausdampfen können.

Bei einer Ausführungsform der Erfindung weist die Titandioxidschicht eine über die Schichtdicke veränderliche Zusammensetzung an Schichtbestandteilen auf. So können beispielsweise photokatalytische Wirkungen der Schichtoberfläche gesteigert werden bzw. höhere Härtegrade der Schicht erzielt werden, wenn die kristallinen Phasen des Titandioxids in den äußeren Bereichen der Titandioxidschicht konzentriert sind.

Wird der äußere Randbereich einer Titandioxidschicht mit hohen Anteilen der Phase Rutil abgeschieden, kann eine hohe Schichthärte erzielt werden. Sollen hingegen eine hohe Benetzbarkeit mit Wasser bzw. eine antibakterielle Wirkung der Schichtoberfläche angestrebt werden, ist es vorteilhaft, den äußeren Randbereich der Titandioxidschicht mit hohen Anteilen der Phase Anatas abzuscheiden.

Zum Abscheiden der Doppelschicht sind sowohl ein plasmaunterstütztes Magnetron-Sputter-Verfahren, wegen der guten geometrischen Anpassbarkeit und Steuerbarkeit der Schichteigenschaften, als auch ein plasmaunterstütztes Bedampfungs-Verfahren, beispielsweise bei extremen Anforderungen an Produktivität bzw. bei großflächig zu beschichtenden Grundkörpern, geeignet. Es ist auch möglich, eine Schicht der Doppelschicht mittels Sputtern abzuscheiden und die andere Schicht mittels Bedampfen. Wichtig beim Abscheiden der Doppelschicht ist jedoch, dass das Prozessvakuum dabei nicht unterbrochen wird.

Bei einer anderen Ausführungsform der Erfindung ist/wird zwischen einem Grundkörper und einer erfindungsgemäßen Doppelschicht mindestens eine weitere Schicht auf dem Grundkörper aufgetragen. Diese Schicht kann beispielsweise als Barriereschicht ausgebildet sein, um zu verhindern, dass Materialbestandteile des Grundkörpers bei Temperatureinwirkung aus dem Grundkörper diffundieren.

Bei einer weiteren Ausführungsform der Erfindung wird die Titandioxidschicht als äußere Schicht eines Objektes mit Dotierungselementen versehen. Dies ist beispielsweise von Vorteil, wenn insbesondere photokatalytische Eigenschaften der Objektoberfläche erwünscht sind. Zum Wirksamwerden photokatalytischer Effekte auf der Oberfläche einer Titandioxidschicht ist es erforderlich, diese Schicht einer UV-Strahlung-auszusetzen. Hierzu sind entweder spezielle UV-Strahlungslampen oder das Einstrahlen von Sonnenlicht, welches jedoch nur einen geringen Anteil von UV-Strahlung aufweist, erforderlich.

Wird die Titandioxidschicht mit entsprechenden Dotierungselementen wie beispielsweise Eisen, Aluminium, Gallium oder Stickstoff versehen, kann die Wellenlänge der Lichtstrahlung, ab welcher photokatalytische Wirkungen der Titandioxidschicht hervorgerufen werden, vom kurzwelligen in den sichtbaren Wellenbereich des Lichtes verschoben werden, wodurch der Einsatz spezieller UV-Strahlungslampen verringert werden kann.

Die Erfindung wird nachfolgend anhand bevorzugter Ausführungsbeispiele näher erläutert. Die einzige Fig. zeigt ein erfindungsgemäßes Objekt, das Teil eines Schreibgerätes ist.

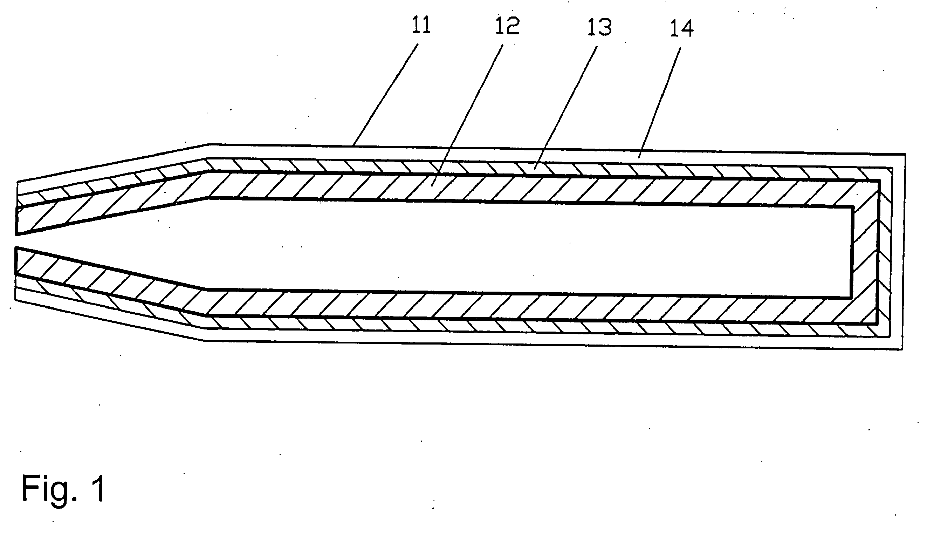

In Fig. 1 ist gemäß eines ersten Beispiels ein Längsschnitt durch ein Gehäuse 11 eines Schreibgerätes schematisch dargestellt, welches einen Grundkörper 12, hergestellt durch Ur- und Umformprozesse aus den Materialien Messing und Edelstahl, aufweist. In einem mehrstufigen mechanischen und chemischen Oberflächenbehandlungsprozess wird auf den sichtbaren Flächen des Grundkörpers 12 eine gleichmäßige Rauheit mit einem Mittenrauheitswert R_{A} von 1,25 µm erzeugt. Diese sichtbaren Flächen werden anschließend in einer Vakuumbeschichtungsanlage mit einer Doppelschicht bestehend aus einer Titanschicht 13 und einer Titandioxidschicht 14 versehen. Dazu werden zahlreiche Grundkörper 12 gemeinsam in einer mehrachsig rotierenden Halterung aufgenommen und mittels Puls-Magnetron-Sputtern beschichtet. Zum Unterstützen der Plasmaaktivierung wird die Halterung auf ein negatives Potenzial von 80 V gelegt. Nach einer Plasmavorbehandlung wird zunächst bei nichtreaktiver Prozessführung die Titanschicht 13 mit einer Dicke von 2 µm und anschließend ohne Vakuumunterbrechung in einem reaktiven sauerstoffhaltigen Gasgemisch die Titandioxidschicht 14 mit einer Dicke von 1 µm abgeschieden. Durch Wahl eines Puls-Pause-Verhältnisses von 1:4 und einer Temperatur von 170 °C wird erreicht, dass die Titandioxidschicht überwiegend aus der Phase Rutil besteht, ohne dass ein Ausdampfen von Zink aus dem Material des Grundkörpers stattfindet. Das Gehäuse 11 des Schreibgerätes erhält durch diese Behandlung mit dem erfindungsgemäßen Verfahren ein seidenmattes edles Aussehen, wird von Handschweiß nicht angegriffen und ist resistent gegen Zerkratzen.

Das zweite Beispiel betrifft ein nicht dargestelltes Griffstück für eine zahnärztliche Bohrturbine, bestehend aus einem Grundkörper, welcher durch mehrstufiges Umformen und Mikroschweißen von Edelstahlteilen gefertigt ist. Die Oberfläche wird durch Feinst-Glaskugelstrahlen auf einen Mittenrauheitswert R_{A} von 0,63 µm eingestellt. In einem Vakuumprozess ähnlich dem ersten Beispiel wird nach einer Plasmavorbehandlung durch nichtreaktives Puls-Magnetron-Sputtern eine Titanschicht und anschließend durch reaktives Puls-Magnetron-Sputtern eine Titandioxidschicht auf dem Grundkörper abgeschieden. Das Puls-Pause-Verhältnis beträgt hier jedoch 1:1 und die Beschichtungstemperatur 350 °C. Die Doppelschicht besteht aus einer hochdichten feinkristallinen Titanschicht mit einer Dicke von 1 µm und einer darüberliegenden Titandioxidschicht, deren Dicke zur Vermeidung interferenzbedingter Farberscheinungen auf mindestens 2 µm eingestellt ist. Durch röntgenstrukturanalytische Untersuchung wurde ein Anteil von etwa 60 Prozent Anatas und ein Anteil von etwa 15 Prozent Rutil identifiziert. Die Kristallitgröße liegt für Anatas im Bereich 200 nm bis 500 nm und für Rutil im Bereich 50 nm bis 100 nm. Für die optisch ansprechenden, kratzfesten und gegen Schweiß und Reinigungsmittel resistenten Griffstücke wurden biomedizinische Laboruntersuchungen durchgeführt. Nach sechsstündiger Auslagerung in Sonnenlicht sind die Griffstücke vollständig mit Wasser benetzbar, d. h. in Randwinkelmessungen ergeben sich Werte unter 10°. Vergleichende Untersuchungen unbelichteter und belichteter Griffstücke ergaben einen Rückgang der Besiedlungsdichte mit Bakterien der Stämme Escherichia coli und Micrococcus luteus um mindestens den Faktor 10⁵ bzw. 10³.

## Patentansprüche

1. Objekt, umfassend einen metallischen Grundkörper (12) mit einer Oberfläche, die zumindest in einem Flächenabschnitt einen Mittenrauheitswert R_{A} größer als 0,4 µm aufweist, wobei in diesem Flächenabschnitt mindestens eine äußere Doppelschicht, bestehend aus einer 0,1 µm bis 5 µm dicken Titanschicht (13) mit porenfreiem Gefüge und einer Deckschicht (14) aus transparentem Titandioxid mit Anteilen der kristallinen Phasen Anatas und/oder Rutil, durch ein plasmaunterstütztes PVD-Verfahren ohne Unterbrechung des Vakuums auf dem Grundkörper aufgebracht ist, wobei die Summe der Anteile der kristallinen Phasen der Titandioxidschicht (14) größer als 20 Prozent ist.

2. Objekt nach Anspruch 1, **dadurch gekennzeichnet, dass** der metallische Grundkörper (12) aus einem der Werkstoffe Stahl, Neusilber, Messing, Bronze, Aluminium oder einer Aluminiumlegierung besteht.

3. Objekt nach einem der vorhergehenden Ansprüche, **dadurch gekennzeichnet, dass** die Titanschicht (13) mit einer Dicke von 0,3 µm bis 0,5 µm ausgebildet ist.

4. Objekt nach einem der vorhergehenden Ansprüche, **dadurch gekennzeichnet, dass** die Titandioxidschicht (14) mit einer Dicke von 0,1 µm bis 5 µm ausgebildet ist.

5. Objekt nach einem der vorhergehenden Ansprüche, **dadurch gekennzeichnet, dass** die Titandioxidschicht (14) eine über die Schichtdicke veränderte Zusammensetzung an Schichtbestandteilen aufweist.

6. Objekt nach Anspruch 5, **dadurch gekennzeichnet, dass** der äußere Randbereich der Titandioxidschicht (14) den höchsten Gehalt an der Phase Anatas oder Rutil aufweist.

7. Objekt nach einem der vorhergehenden Ansprüche, **dadurch gekennzeichnet, dass** die Titanschicht (13) oder/und die Deckschicht (14) durch ein Magnetron-Sputterverfahren oder durch ein Bedampfungsverfahren abscheidbar ist/sind.

8. Objekt nach einem der vorhergehenden Ansprüche, **dadurch gekennzeichnet, dass** sich zwischen Grundkörper und Doppelschicht mindestens eine weitere Schicht befindet.

9. Objekt nach einem der vorhergehenden Ansprüche, **dadurch gekennzeichnet, dass** die Titandioxidschicht (14) eine Dotierung aufweist.

10. Verwendung des Objektes nach einem der vorhergehenden Ansprüche als Teil eines
Haushaltsgegenstandes oder
Sanitärartikels oder
Werkzeuges oder
chirurgischen Instruments oder
dentalmedizinischen Gerätes oder
Erzeugnisses der Uhren- oder Schmuckindustrie.

11. Verfahren zum Veredeln eines Objektes, welches mindestens einen metallischen Grundkörper (12) umfasst, **dadurch gekennzeichnet, dass** die Oberfläche des Grundkörpers (12) zumindest in einem Flächenabschnitt mit einer Struktur versehen wird, die einen Mittenrauheitswert R_{A} größer als 0,4 µm aufweist, wobei in diesem Flächenabschnitt mindestens eine äußere Doppelschicht, bestehend aus einer 0,1 µm bis 5 µm dicken Titanschicht (13) mit porenfreiem Gefüge und einer Deckschicht (14) aus transparentem Titandioxid mit Anteilen kristalliner Phasen Anatas und/oder Rutil, durch ein plasmaunterstütztes PVD-Verfahren auf dem Grundkörper ohne Unterbrechung des Vakuums abgeschieden wird, wobei die Summe der Anteile der kristallinen Phasen der Titandioxidschicht (14) größer als 20 Prozent eingestellt wird.

12. Verfahren nach Anspruch 11, **dadurch gekennzeichnet, dass** die Titanschicht (13) mit einer Dicke von 0,3 µm bis 0,5 µm abgeschieden wird.

13. Verfahren nach einem der vorhergehenden Ansprüche, **dadurch gekennzeichnet, dass** die Titandioxidschicht (14) mit einer Dicke von 0,1 µm bis 5 µm abgeschieden wird.

14. Verfahren nach einem der vorhergehenden Ansprüche, **dadurch gekennzeichnet, dass** die Titandioxidschicht (14) mit einer über der Schichtdicke veränderten Zusammensetzung an Schichtbestandteilen abgeschieden wird.

15. Verfahren nach Anspruch 14, **dadurch gekennzeichnet, dass** der äußere Randbereich der Titandioxidschicht (14) mit dem höchsten Gehalt an der Phase Anatas oder Rutil abgeschieden wird.

16. Verfahren nach einem der vorhergehenden Ansprüche, **dadurch gekennzeichnet, dass** die Titanschicht (13) oder/und die Deckschicht (14) durch ein Magnetron-Sputterverfahren oder durch ein Bedampfungsverfahren abgeschieden wird/werden.

17. Verfahren nach einem der vorhergehenden Ansprüche, **dadurch gekennzeichnet, dass** zwischen Grundkörper und Doppelschicht mindestens eine weitere Schicht abgeschieden wird.

18. Verfahren nach einem der vorhergehenden Ansprüche, **dadurch gekennzeichnet, dass** die Titandioxidschicht (14) mit einer Dotierung abgeschieden wird.

## Claims

1. Object comprising a metallic base body (12) with a surface having a mean roughness value R_{A} of greater than 0.4 µm at least in one surface portion, wherein at least one outer double layer, which comprises a 0.1 µm to 5 µm-thick titanium layer (13) with a pore-free microstructure and a top layer (14) of transparent titanium dioxide with anatase and/or rutile crystalline phase fractions, is applied to the base body in this surface portion by means of a plasma-assisted PVD process, without interrupting the vacuum, wherein the sum of the crystalline phase fractions in the titanium dioxide layer (14) is greater than 20 percent.

2. Object according to Claim 1, **characterized in that** the metallic base body (12) consists of one of the following materials: steel, nickel silver, brass, bronze, aluminium or an aluminium alloy.

3. Object according to either of the preceding claims, **characterized in that** the titanium layer (13) is embodied with a thickness of from 0.3 µm to 0.5 µm.

4. Object according to one of the preceding claims, **characterized in that** the titanium dioxide layer (14) is embodied with a thickness of from 0.1 µm to 5 µm.

5. Object according to one of the preceding claims, **characterized in that** the titanium dioxide layer (14) has a layer constituent composition which varies over the layer thickness.

6. Object according to Claim 5, **characterized in that** the outer edge region of the titanium dioxide layer (14) has the highest content of the anatase or rutile phase.

7. Object according to one of the preceding claims, **characterized in that** the titanium layer (13) and/or the top layer (14) can be deposited by means of a magnetron sputtering process or by means of a vapour deposition process.

8. Object according to one of the preceding claims, **characterized in that** at least one further layer is located between the base body and the double layer.

9. Object according to one of the preceding claims, **characterized in that** the titanium dioxide layer (14) has a doping.

10. Use of the object according to one of the preceding claims as part of a
household article or
sanitary article or
tool or
surgical instrument or
dentistry appliance or
product of the horological or jewellery industry.

11. Process for improving an object comprising at least one metallic base body (12), **characterized in that** the surface of the base body (12), at least in one surface portion, is provided with a structure having a mean roughness value R_{A} of greater than 0.4 µm, wherein at least one outer double layer, which comprises a 0.1 µm to 5 µm-thick titanium layer (13) with a pore-free microstructure and a top layer (14) of transparent titanium dioxide with anatase and/or rutile crystalline phase fractions, is deposited on the base body in this surface portion by means of a plasma-assisted PVD process, without interrupting the vacuum, wherein the sum of the crystalline phase fractions in the titanium dioxide layer (14) is set to be greater than 20 percent.

12. Process according to Claim 11, **characterized in that** the titanium layer (13) is deposited with a thickness of from 0.3 µm to 0.5 µm.

13. Process according to either of the preceding claims, **characterized in that** the titanium dioxide layer (14) is deposited with a thickness of from 0.1 µm to 5 µm.

14. Process according to one of the preceding claims, **characterized in that** the titanium dioxide layer (14) is deposited with a layer constituent composition which varies over the layer thickness.

15. Process according to Claim 14, **characterized in that** the outer edge region of the titanium dioxide layer (14) is deposited with the highest content of the anatase or rutile phase.

16. Process according to one of the preceding claims, **characterized in that** the titanium layer (13) and/or the top layer (14) are/is deposited by means of a magnetron sputtering process or by means of a vapour deposition process.

17. Process according to one of the preceding claims, **characterized in that** at least one further layer is deposited between the base body and the double layer.

18. Process according to one of the preceding claims, **characterized in that** the titanium dioxide layer (14) is deposited with a doping.

## Revendications

1. Objet comprenant un corps métallique de base (12) dont au moins une partie d'une surface présente un indice moyen de rugosité R_{A} supérieur à 0,4 µm, au moins une double couche extérieure constituée d'une couche (13) de titane d'une épaisseur de 0,1 µm à 5 µm à réseau exempt de pores et d'une couche de recouvrement (14) en dioxyde de titane transparent dont certaines fractions ont une phase cristalline anatase et/ou rutile étant appliquée sur cette partie de surface du corps de base par un procédé de PVD soutenu par plasma sans interruption du vide, la somme des fractions de phases cristallines de la couche (14) de dioxyde de titane étant supérieure à 20 pourcent.

2. Objet selon la revendication 1, **caractérisé en ce que** le corps métallique de base (12) est constitué d'un des matériaux acier, argentan, laiton, bronze, aluminium et alliages d'aluminium.

3. Objet selon l'une des revendications précédentes, **caractérisé en ce que** la couche (13) de titane est formée à une épaisseur de 0,3 µm à 0,5 µm.

4. Objet selon l'une des revendications précédentes, **caractérisé en ce que** la couche (14) de dioxyde de titane est formée à une épaisseur de 0,1 µm à 5 µm.

5. Objet selon l'une des revendications précédentes, **caractérisé en ce que** la composition en composants de la couche (14) de dioxyde de titane varie selon l'épaisseur de la couche.

6. Objet selon la revendication 5, **caractérisé en ce que** la bordure extérieure de la couche (14) de dioxyde de titane présente la plus forte teneur en phase anatase ou rutile.

7. Objet selon l'une des revendications précédentes, **caractérisé en ce que** la couche (13) de titane et/ou la couche de recouvrement (14) sont déposées par un procédé de pulvérisation à magnétron ou par un procédé de vaporisation.

8. Objet selon l'une des revendications précédentes, **caractérisé en ce qu'**au moins une autre couche est située entre le corps de base et la double couche.

9. Objet selon l'une des revendications précédentes, **caractérisé en ce que** la couche (14) de dioxyde de titane présente un dopage.

10. Utilisation de l'objet selon l'une des revendications précédentes comme partie d'un objet domestique, d'un article sanitaire, d'un outil, d'un instrument chirurgical, d'un appareil de la médecine dentaire ou d'un produit du secteur horloger ou du secteur des bijoux.

11. Procédé de finition d'un objet qui comporte au moins un corps métallique de base (12), **caractérisé en ce qu'**au moins une partie de la surface du corps de base (12) est dotée d'une structure dont l'indice moyen de rugosité R_{A} est supérieur à 0,4 µm, au moins une double couche extérieure constituée d'une couche (13) de titane d'une épaisseur de 0,1 µm à 5 µm à réseau exempt de pores et d'une couche de recouvrement (14) en dioxyde de titane transparent dont certaines fractions ont une phase cristalline anatase et/ou rutile étant appliquée sur cette partie de surface du corps de base par un procédé de PVD soutenu par plasma sans interruption du vide, la somme des fractions de phases cristallines de la couche (14) de dioxyde de titane étant supérieure à 20 pourcent.

12. Procédé selon la revendication 11, **caractérisé en ce que** la couche (13) de titane est déposée à une épaisseur de 0,3 µm à 0,5 µm.

13. Procédé selon l'une des revendications précédentes, **caractérisé en ce que** la couche (14) de dioxyde de titane est déposée à une épaisseur de 0,1 µm à 5 µm.

14. Procédé selon l'une des revendications précédentes, **caractérisé en ce que** la couche (14) de dioxyde de titane est déposée à une composition en composants de la couche qui varie selon l'épaisseur de la couche.

15. Procédé selon la revendication 14, **caractérisé en ce que** la bordure extérieure de la couche (14) de dioxyde de titane est déposée à la plus forte teneur en phase anatase ou rutile.

16. Procédé selon l'une des revendications précédentes, **caractérisé en ce que** la couche (13) de titane et/ou la couche de recouvrement (14) sont déposées par un procédé de pulvérisation à magnétron ou par un procédé de vaporisation.

17. Procédé selon l'une des revendications précédentes, **caractérisé en ce qu'**au moins une autre couche est déposée entre le corps de base et la double couche.

18. Procédé selon l'une des revendications précédentes, **caractérisé en ce que** la couche (14) de dioxyde de titane est déposée avec un dopage.
